# EUROPEAN PATENT APPLICATION

(11) **EP 2 169 760 A1**
(43) Date of publication of application: **31.03.2010**
(21) Application number: 07828904.8
(22) Date of filing: 01.10.2007
(51) Int. Cl.: H01M 16/00, H01M 10/44, H02J 7/02

(54) **BATTERY PACK AND BATTERY SYSTEM**

(30) Priority: 18.05.2007 JP 2007132732
(71) Applicant: Panasonic Corporation, Kadoma-shi Osaka 571-8501 (JP)
(72) Inventor: NAKASHIMA Takuya c/o Panasonic Corporation, Chuo-ku Osaka-shi Osaka 540-6207 (JP); OAKI Mamoru c/o Panasonic Corporation, Chuo-ku Osaka-shi Osaka 540-6207 (JP); SUGIYAMA Shigeyuki c/o Panasonic Corporation, Chuo-ku Osaka-shi Osaka 540-6207 (JP)
(74) Representative: Schwabe - Sandmair - Marx
(86) International application number: PCT/JP2007/069164
(87) International publication number: WO 2008/142811

(57) **Abstract**

There are provided at least one aqueous secondary battery and at least one nonaqueous secondary battery having a smaller capacity than that of the aqueous secondary battery. The aqueous secondary battery and the nonaqueous secondary battery are connected in series to constitute a battery pack.

## Description

### Technical Field

This invention relates to a battery pack comprising a plurality of secondary batteries, and to a battery system comprising this battery pack.

### Background Art

Lead storage batteries have conventionally been installed in motor vehicles of two, three, four, or more wheels to drive electric devices and electrical circuits and to start the power train. Lead storage batteries are inexpensive, but they also have low energy storage density, so they are heavy and bulky. From the standpoints of the vehicle's fuel economy and power performance, there is a need to make such batteries lighter and more compact. One method for improving this situation is to use a nickel-cadmium secondary battery, a nickel-hydrogen secondary battery, a lithium ion secondary battery, or a lithium-polymer secondary battery, which have higher energy storage density. There have also been proposals for battery packs that include different types of batteries, in order to solve the problems associated with battery packs made up of all the same type of batteries (see Patent Document 1, for example).

A constant current, constant voltage (CCCV) type of charging, in which charging at a constant current is followed by charging at a constant voltage, is employed to charge lead storage batteries. When constant voltage charging is performed, a constant voltage is applied to a secondary battery while the charging current flowing to the secondary battery is detected, and the charging is halted once the charging current drops below a preset charging cut-off voltage value. However, when an aqueous secondary battery such as a nickel-cadmium secondary battery or a nickel-hydrogen secondary battery is charged at a constant voltage, the temperature increase that accompanies oxygen generation, which is a side reaction that occurs near full charge, decreases the open circuit voltage of the cell, the charging current begins to increase, and constant voltage charging cannot be ended because the charging current never drops below the charging cut-off current value, so charging continues and results in overcharging. As a result, the overcharging causes fluid to leak out, and this adversely affects battery function. Accordingly, with vehicles equipped with a charging circuit for a lead storage battery, a problem has been that aqueous secondary batteries cannot be installed in place of lead storage batteries.

A lithium ion secondary battery, a lithium-polymer secondary battery, or another such nonaqueous secondary battery can also be charged by the same constant current, constant voltage (CCCV) charging method as lead storage batteries. However, when a nonaqueous secondary battery is installed in place of a lead storage battery in a vehicle equipped with a charging circuit for a lead storage battery, a problem is that proper charging cannot be performed since the charging voltage is different for a lead storage battery and a nonaqueous secondary battery.

For example, with a lead storage battery having a power of DC 12 V, constant voltage charging is generally performed at 14.0 V to 14.5 V. 14.5 V in particular is usually used as the charging voltage for a lead storage battery in racing vehicles.

When a charging circuit for charging a lead storage battery is used to charge a battery pack in which a plurality of lithium ion secondary batteries are connected in series, the charging voltage per lithium ion secondary battery is, for example, the voltage obtained by dividing 14.5 V by the number of lithium ion secondary batteries. For example, with a battery pack in which three lithium ion secondary batteries are connected in series, the charging voltage per lithium ion secondary battery is 14.5 V /3 = 4.83 V.

Meanwhile, the charging voltage when a lithium ion secondary battery is charged at a constant voltage is 4.2 V, which is the open voltage in a fully charged state of a lithium ion secondary battery. Thus, if a battery pack comprising three lithium ion secondary batteries connected in series is charged with a charging circuit intended for a lead storage battery, the charging voltage will be too high, and overcharging can adversely affect characteristics or lead to malfunction, and there is even the risk of safety problems.

With a battery pack in which four lithium ion secondary batteries are connected in series, the charging voltage per lithium ion secondary battery is 14.5 V /4 = 3.63 V, so the charging voltage is too low with respect to the 4.2 V, and the charging depth (SOC) only reaches about 50%, so a problem is that it is difficult to utilize the capacity of the secondary batteries effectively.

Also, with the technology discussed in Patent Document 1, a property is utilized whereby more heat is generated near a full charge of an aqueous secondary battery, and whether or not a full charge has been attained is determined from the temperature of a battery pack in which aqueous secondary batteries and nonaqueous secondary batteries are both used. However, with a charging circuit intended for constant voltage charging, such as a charging circuit intended for a lead storage battery, a full charge is determined and the charging ended on the basis of the charging current, so if the battery pack discussed in Patent Document 1 is charged with a charging circuit intended for constant voltage charging, the charging cannot be ended, and overcharging can adversely affect characteristics or lead to malfunction, and there is even the risk of safety problems. Also, since heat is generated near full charge with an aqueous secondary battery, a problem is that nonaqueous secondary batteries that are combined with aqueous secondary batteries undergo deterioration under heating.
Patent Document 1: Japanese Laid-Open Patent Application H9-180768

### Disclosure of the Invention

The present invention was conceived in light of this situation, and it is an object thereof to provide a battery pack with which it is easy to increase the charging depth at the end of charging while reducing the risk of overcharging, even when charging with a charging circuit intended for constant voltage charging, as well as a battery system in which this battery pack is used.

The battery pack pertaining to one aspect of the present invention comprises at least one aqueous secondary battery and at least one nonaqueous secondary battery having a smaller capacity than that of the aqueous secondary battery, wherein the aqueous secondary battery and the nonaqueous secondary battery are connected in series.

The battery system pertaining to one aspect of the present invention comprises the above-mentioned battery pack and the charging circuit.

With a battery pack and battery system constituted as above, when the battery pack is charged by constant voltage charging, since the charging current flowing through the aqueous secondary battery is equal to the charging current flowing through the nonaqueous secondary battery, the nonaqueous secondary battery, which has a smaller capacity, is reduced in charging current first as full charge is approached, and their constant voltage charging ends first. As a result, when the charging is ended, the aqueous secondary battery, which has a larger capacity than that of the nonaqueous secondary battery, has not yet reached full charge, so there is less risk of overcharging. Furthermore, when the aqueous secondary battery and the nonaqueous secondary battery with different battery characteristics are combined, a wider range of charging characteristics can be obtained by this combination than when secondary battery of the same type are connected in series, so it is easier to increase the charging depth at the end of charging, with the charging characteristics of the entire battery pack matched to a specific charging voltage.

Also, the battery system pertaining to one aspect of the present invention comprises the above-mentioned battery pack, a switching element that opens and closes a discharge path to the load device of the battery pack, a voltage detector that detects a voltage between both ends of the battery pack, and a controller that opens the switching element when a voltage detected by the voltage detector has dropped below a detected discharge cut-off voltage, which is preset to a voltage that is lower than the total voltage comprising the sum of a voltage obtained by multiplying the number of the aqueous secondary battery included in the serial circuit by the mid-point discharge voltage of the aqueous secondary battery, and a voltage obtained by multiplying the number of the nonaqueous secondary battery included in the serial circuit by the mid-point discharge voltage of the nonaqueous secondary battery, and that is higher than the total voltage comprising the sum of a voltage obtained by multiplying the number of the aqueous secondary battery included in the serial circuit by the mid-point discharge voltage of the aqueous secondary battery, and a voltage obtained by multiplying the number of the nonaqueous secondary battery included in the serial circuit by the discharge cut-off voltage of the nonaqueous secondary battery.

With this constitution, when the voltage between both ends of the battery pack detected by the voltage detector drops below a detected discharge cut-off voltage, the controller opens the switching element, which shuts off the discharge current of the battery pack.

The detected discharge cut-off voltage is set to be lower than the total voltage comprising the sum of a voltage obtained by multiplying the number of the aqueous secondary battery by the mid-point discharge voltage of the aqueous secondary battery, and a voltage obtained by multiplying the number of the nonaqueous secondary battery by the mid-point discharge voltage of the nonaqueous secondary battery. Accordingly, the aqueous secondary battery and nonaqueous secondary battery each output an mid-point discharge voltage, and when the end of discharge has not yet been reached, the voltage between both ends of the battery pack does not drop below the detected discharge cut-off voltage, and therefore the switching element is not opened by the controller, so discharge continues.

Furthermore, the detected discharge cut-off voltage is set to a voltage that is higher than the total voltage comprising the sum of a voltage obtained by multiplying the number of the aqueous secondary battery by the mid-point discharge voltage of the aqueous secondary battery, and a voltage obtained by multiplying the number of the nonaqueous secondary battery by the discharge cut-off voltage of the nonaqueous secondary battery. Accordingly, when the nonaqueous secondary battery, which has a smaller capacity than that of the aqueous secondary battery, reach the end of discharge first and the terminal voltage of the nonaqueous secondary battery decreases, the voltage between both ends of the battery pack drops below the detected discharge cut-off voltage before the terminal voltage of the nonaqueous secondary battery drops below the discharge cut-off voltage. Thus, the controller opens the switching element and the discharge current of the battery pack is shut off, so the nonaqueous secondary battery and aqueous secondary battery are less apt to be in an overdischarging state.

### Brief Description of the Drawings

[FIG. 1] FIG. 1 is an oblique view illustrating an example of the appearance of a battery pack pertaining to an embodiment of the present invention;
[FIG. 2] FIG. 2 is a schematic diagram illustrating an example of the electrical configuration of the battery system pertaining to an embodiment of the present invention;
[FIG. 3] FIG. 3 is a graph illustrating an example of the charging time, the terminal voltage of each lithium ion secondary battery and each nickel-hydrogen secondary battery, and the total voltage, when a battery pack undergoes constant current, constant voltage charging with the charging circuit shown in FIG. 2;
[FIG. 4] FIG. 4 is a graph of the results of measuring the charging current Ib, the charging voltage Vb, the terminal voltage V1 of lithium ion secondary batteries, and the terminal voltage V2 of nickel-hydrogen secondary batteries, when constant current, constant voltage (CCCV) charging was performed on the battery pack shown in FIG. 2 at a temperature of 45°C, with the charging current during constant current charging set to 2.5 A, and the charging voltage during constant voltage charging set to 14.5 V;
[FIG. 5] FIG. 5 is a graph of the results of measuring the terminal voltage Vb of the battery pack, the terminal voltage V1 of the lithium ion secondary batteries, and the terminal voltage V2 of the nickel-hydrogen secondary batteries in discharge of the battery pack shown in FIG. 2 at 10A and at a temperature of 45°C; and
[FIG. 6] FIG. 6 is a diagram illustrating a modification example of the battery system shown in FIG. 2.

### Best Mode for Carrying Out the Invention

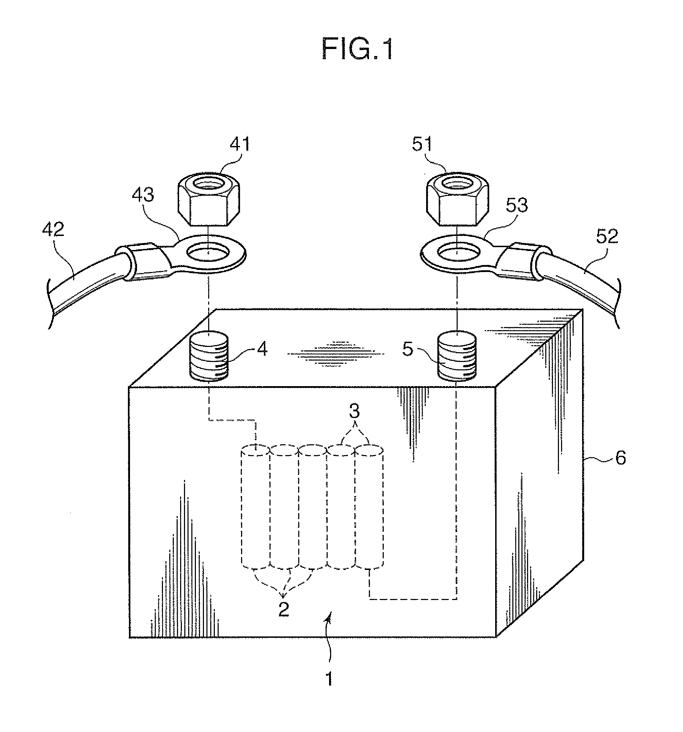

Embodiments of the present invention will now be described through reference to the drawings. Components that are numbered the same in the drawings have the same constitution, and will not be described more than once. FIG. 1 is an oblique view illustrating an example of the appearance of a battery pack pertaining to an embodiment of the present invention. The battery pack 1 shown in FIG. 1 is used an automotive battery that is installed, for example, in a two- or four-wheeled vehicle, a construction vehicle, or the like. The battery pack 1 shown in FIG. 1 has, for example, three lithium ion secondary batteries 2 and two nicker-hydrogen secondary batteries 3 that are connected in series and housed in a substantially box-shaped case 6.

Connecting terminals 4 and 5 protrude upward from the upper face of the case 6. In the example in FIG. 1, the connection terminals 4 and 5 are in the form of bolts, which can be screwed with nuts 41 and 51. A wiring terminal 43 in the form of a ring that can fit onto with the connection terminal 4 is fixed by caulking or another such means to the terminal of a cable 42 that is to be connected to the connection terminal 4. Similarly, a wiring terminal 53 in the form of a ring that can fit onto with the connection terminal 5 is fixed by caulking or another such means to the terminal of a cable 52 that is to be connected to the connection terminal 5. The wiring terminals 43 and 53 are fitted over the connection terminal 4 and the connection terminal 5, respectively, of the battery pack 1, and the nuts 41 and 51 are attached onto the connection terminals 4 and 5 and tightened, which electrically connects the terminals of the cables 42 and 52 to the connection terminals 4 and 5.

The cables 42 and 52 are connected to an electrical circuit in a vehicle, to a charging circuit that charges the battery pack 1, etc., and are used to charge and discharge the battery pack 1.

The connection terminals 4 and 5 do not have to be in the form of bolts, and may instead be in the form of cylinders, for example. The wiring terminals 43 and 53 may be formed, for example, from an electroconductive metal sheet whose middle portion has been worked into substantially a C shape. After these middle portions have been loosely fitted with the outside of the connection terminals 4 and 5, at both ends of the wiring terminals 43 and 53 are tightened with bolts or the like, which couples the connection terminals 4 and 5 and the wiring terminals 43 and 53. With a case structure and terminal structure such as the above, it is easy to replace an automotive lead storage battery with the battery pack 1 and to connect the wiring terminals 43 and 53 for connecting to a charging circuit intended for a lead storage battery, for example.

Also, the battery pack 1 does not necessarily have to be housed in the case 6, and is not limited to comprising connection terminals that can be connected directly to the wiring terminals 43 and 53 intended for a lead storage battery. The connection terminals 4 and 5 may, for example, be a terminal block, a connector, or a cell electrode terminal itself.

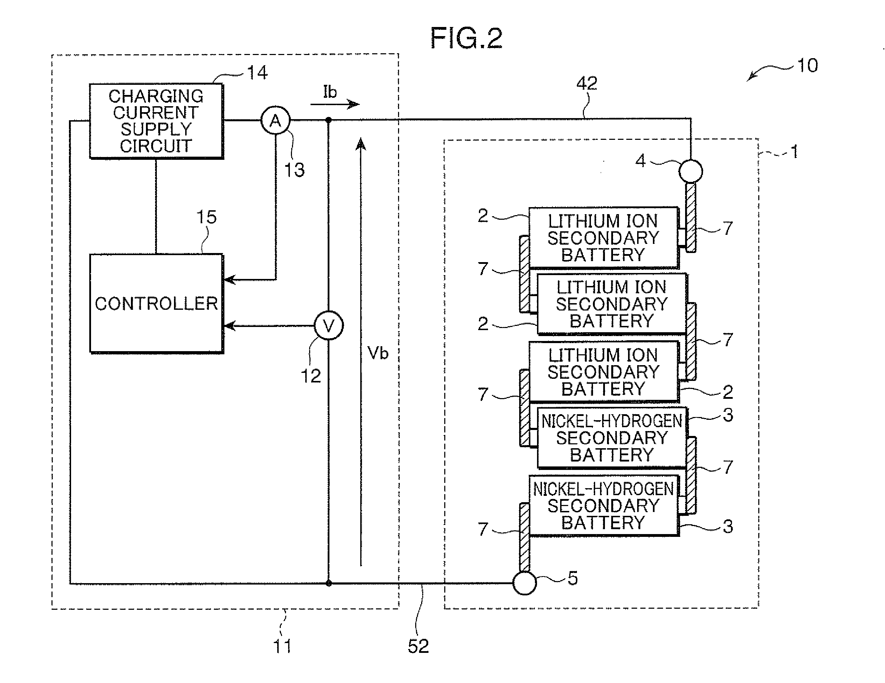

FIG. 2 is a schematic diagram illustrating an example of the electrical configuration of a battery system 10 comprising the battery pack 1 shown in FIG. 1 and a charging circuit 11 for charging the battery pack 1. The battery pack 1 shown in FIG. 2 is constituted such that three lithium ion secondary batteries 2 and two nickel-hydrogen secondary batteries 3 are connected in series by connector plates 7. Both ends of the serial circuit of the three lithium ion secondary batteries 2 and the two nickel-hydrogen secondary batteries 3 are connected with the connection terminals 4 and 5 by the connector plates 7. In FIG. 1, batteries of the same type are disposed in proximity, but batteries of different types may be disposed alternately instead.

The lithium ion secondary batteries 2 have a single-cell capacity that is smaller than that of the nickel-hydrogen secondary batteries 3. The lithium ion secondary batteries 2 correspond to an example of nonaqueous secondary batteries, and lithium-polymer secondary batteries or other such nonaqueous secondary batteries may be used instead of the lithium ion secondary batteries 2.

The nickel-hydrogen secondary batteries 3 correspond to an example of aqueous secondary batteries, and nickel-cadmium secondary batteries or other such aqueous secondary batteries may be used instead of the nickel-hydrogen secondary batteries 3. However, it is preferable to use nickel-hydrogen secondary batteries as the aqueous secondary batteries and to use lithium ion secondary batteries as the nonaqueous secondary batteries because the energy density is higher and the batteries will be lighter and more compact.

The mid-point discharge voltage, which is the standard power voltage, of the lithium ion secondary batteries 2, is about 3.6 V, and the mid-point discharge voltage of the nickel-hydrogen secondary batteries 3 is about 1.1 V to 1.2 V. Specifically, the battery pack 1 shown in FIG. 2 is made up of aqueous secondary batteries and nonaqueous secondary batteries, which have a higher mid-point discharge voltage than the aqueous secondary batteries, that are connected in series.

An example will now be given of how to find the mid-point discharge voltage of a cell. When nickel-hydrogen secondary batteries or other such aqueous secondary batteries are used as the cells, the cells are subjected to constant current charging for 1.2 hours at a current of I ItA (1 ItA here is the current value obtained by dividing the theoretical capacity of the cell by one hour), after which constant current discharge is performed at 1 ItA until 1 V is reached to find the discharge capacity, and the discharge voltage at which this discharge capacity reaches the 50% point can be specified as the mid-point discharge voltage.

When lithium ion secondary batteries are used as the cells, the cells are subjected to constant current charging at a current of 0.7 ItA until 4.2 V is reached, and after 4.2 V has been reached, constant voltage charging is performed until the current value attenuates to 0.05 ItA, after which constant current discharging is performed at 1 ItA until 2.5 V is reached to find the discharge capacity, and the discharge voltage at which this discharge capacity reaches the 50% point can be specified as the mid-point discharge voltage.

The nominal voltage of each cell as published by the battery manufacturer is substantially equal to the mid-point discharge voltage, so the nominal voltage may be used as the mid-point discharge voltage.

The charging circuit 11 is, for example, a charging circuit that charges an automotive lead storage battery by constant current, constant voltage (CCCV), and is constituted, for example, by an automotive ECU (electronic control unit). The charging circuit 11 comprises, for example, a voltage sensor 12 (voltage detector), a current sensor 13, a charging current supply circuit 14, and a controller 15.

The charging current supply circuit 14 comprises, for example, a rectifying circuit that produces charging voltage and charging current for charging a lead storage battery, from power generated by a motor vehicle; a switching power supply circuit; and so forth. The charging current supply circuit 14 is connected to the connection terminal 4 via the current sensor 13 and the cable 42, and is connected to the connection terminal 5 via the cable 52.

The voltage sensor 12 comprises, for example, a dividing resistor, an A/D converter, and so forth. The voltage sensor 12 detects the voltage between the connection terminals 4 and 5, in other words, the charging voltage Vb of the battery pack 1, via the cables 42 and 52, and outputs this voltage value to the controller 15. The current sensor 13 comprises, for example, a shunt resistor, a Hall element, an A/D converted, and so forth. The current sensor 13 detects the charging current Ib supplied from the charging current supply circuit 14 to the battery pack 1, and outputs this current value to the controller 15.

The controller 15 comprises, for example, a CPU (central processing unit) that executes specific computation processing, a ROM (read only memory) that stores specific control programs, a RAM (random access memory) that temporarily stores data, peripheral circuits for these, and so forth. The controller 15 is a control circuit that executes the control programs stored in the ROM, and executes constant current, constant voltage (CCCV) charging by controlling the output current and output voltage of the charging current supply circuit 14 on the basis of the charging voltage Vb obtained from the voltage sensor 12 and the charging current Ib obtained from the current sensor 13.

The charging voltage when a lead storage battery is charged by constant voltage charging is generally 14.5 V to 15.5 V. Accordingly, the controller 15 controls the output current and voltage of the charging current supply circuit 14 so that the detected voltage in performing constant voltage charging will be between 14.5 V and 15.5 V.

With a lithium ion secondary battery, the open voltage in a fully charged state is approximately 4.2 V. With lithium ion secondary batteries, as the charging proceeds and the charging depth increases, the positive electrode potential increases and the negative electrode potential decreases. There is a difference in the terminal voltage of a lithium ion secondary battery between the positive and negative electrode potentials.

As the charging depth increases, the negative electrode potential decreases, and the difference between the positive and negative electrode potentials when the negative electrode potential has reached 0 V, that is the positive electrode potential, is affected by variance in the composition of the active material of the positive and negative electrodes, the temperature, and the charging current value, but is known to be approximately 4.2 V when lithium cobalt oxide is used as the cathode material, and approximately 4.3 V when lithium manganese oxide is used as the cathode material. Thus, a full charge is when the negative electrode potential has reached 0 V, and a lithium ion secondary battery can be fully charged (to a charging depth of 100%) by using 4.2 V as the charging voltage in constant voltage charging, for example.

Meanwhile, a characteristic of an aqueous secondary battery is that it exhibits substantially constant terminal voltage with respect to changes in the charging depth. For instance, with a nickel-hydrogen secondary battery, the open voltage in a fully charge state is approximately 1.4 V.

Thus, with the battery system 10, when constant voltage charging of the battery pack 1 is performed at a charging voltage Vb of 14.5 V, for example, the charging voltage for each of the lithium ion secondary batteries 2 is (14.5 V - (1.4 V x 2))/3 = 3.9 V, and the charging voltage of the lithium ion secondary batteries 2 can be raised from the 3.63 V for each of the lithium ion secondary batteries when four lithium ion secondary batteries are connected in series, as discussed above.

Specifically, the 15.4 V that is the total voltage comprising the sum of the voltage obtained by multiplying the 4.2 V that is the open voltage of the lithium ion secondary batteries in a fully charged state by 3, and the voltage obtained by multiplying the open voltage of 1.4 V of the nickel-hydrogen secondary batteries in a fully charged state by 2, is closer to the charging voltage of 14.5 V used for lead storage batteries, than the voltage of 16.8 V obtained by multiplying the 4.2 V that is the open voltage of the lithium ion secondary batteries in a fully charged state by 4. In this case, the charging depth of the lithium ion secondary batteries 2 at the end of charging is approximately 73%, which means that the charging depth of the lithium ion secondary batteries 2 at the end of charging can be increased.

The above-mentioned total voltage is given to be at least the 14.5 V charging voltage used for lead storage batteries, so when the charging voltage used for lead storage batteries is applied between the connection terminals 4 and 5, the charging voltage applied to each of the lithium ion secondary batteries 2 is less than 4.2 V, and as a result, the deterioration of the lithium ion secondary batteries 2 can be reduced, and there is less risk that safety will be compromised.

The power voltage of a lead storage battery comes in multiples of 12 V (12 V, 24 V, 42 V), and the charging voltage of the charging circuit that charges this lead storage battery is also a multiple of 14.5 V to 15.5 V. In view of this, a battery pack in which two nickel-hydrogen secondary batteries are connected in series with three lithium ion secondary batteries that have a smaller capacity than the nickel-hydrogen secondary batteries serves as a single unit, and if the number of the nickel-hydrogen secondary batteries and the number of the lithium ion secondary batteries is set to a ratio of 2:3 by increasing or decreasing the number of these units according to the charging voltage of the charging circuit, then just as when the power voltage of the lead storage battery is 12 V, the charging voltage of the battery pack can be matched to the power voltage of the charging circuit, and the charging depth at the end of charging when the battery pack 1 is charged by this charging circuit can be increased.

Using a unit thus constituted as the basic unit, it is possible to connect several units in series and parallel, or in series-parallel, according to the desired electromotive force, battery capacity, and so forth.

The charging voltage of the charging device is not limited to 14.5 V. Nor is the ratio between the number of the aqueous secondary batteries and the number of the nonaqueous secondary batteries limited to 2:3. The charging voltage, the serial number of aqueous secondary batteries, and the serial number of nonaqueous secondary batteries may be selected so that the total voltage comprising the sum of the voltage obtained by multiplying the serial number of aqueous secondary batteries by the terminal voltage (such as approximately 1.4 V) of the aqueous secondary batteries in a fully charged state, and the voltage obtained by multiplying the serial number of nonaqueous secondary batteries by the terminal voltage (such as approximately 4.2 V) of the nonaqueous secondary batteries in a fully charged state, is closer to the charging voltage of the charging device than the voltage closest to the charging voltage of the charging device out of the voltages obtained by taking integer multiples of the terminal voltage (such as approximately 4.2 V) of the nonaqueous secondary batteries in a fully charged state.

However, for the charging voltage of 14.5 V used as the charging voltage of a lead storage battery, a battery pack in which two nickel-hydrogen secondary batteries and three lithium ion secondary batteries are connected in series is favorable. The phrase "substantially 14.5 V" means that there is some allowance in the fluctuation for 14.5 V due to variance in characteristics, output precision error in the charging device, and so forth, and refers to 14.5 V ±0.1 V, for example.

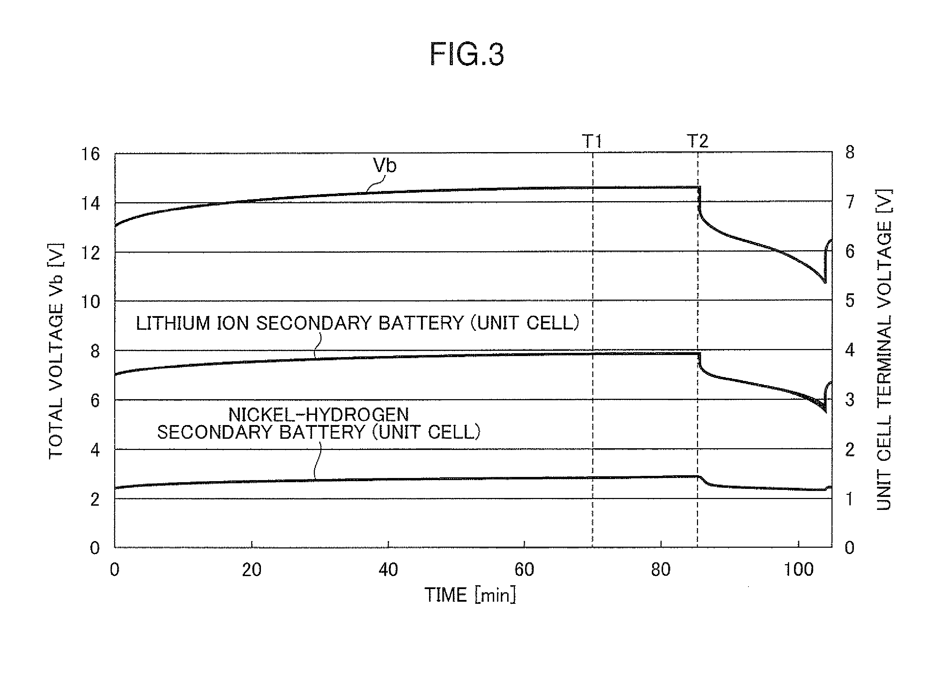

Next, the operation of the battery system 10 constituted as above will be described. FIG. 3 is a graph illustrating an example of the total voltage Vb, that is, the voltage between the connection terminals 4 and 5, the terminal voltage of the lithium ion secondary batteries 2 and the nickel-hydrogen secondary batteries 3, and the charging time when the battery pack 1 underwent constant current, constant voltage (CCCV) charging with the charging circuit 11 shown in FIG. 2. The horizontal axis is the charging time, the right vertical axis is the terminal voltage of the unit cells of the lithium ion secondary batteries 2 and nickel-hydrogen secondary batteries 3, and the left vertical axis is the total voltage Vb.

First, a charging current Ib of 2 A is outputted from the charging current supply circuit 14 through the cable 42 to the battery pack 1 in response to a control signal from the controller 15, and the battery pack 1 is charged at a constant current of 2 A. As a result, the terminal voltage of the lithium ion secondary batteries 2 and nickel-hydrogen secondary batteries 3 rises as the charging proceeds, and the total voltage Vb also rises.

Here, the terminal voltage of the nickel-hydrogen secondary batteries 3 rises very little, and remains almost constant during charging. On the other hand, the terminal voltage of the lithium ion secondary batteries 2 increases in a rising curve as charging proceeds. As a result, the total voltage Vb increases in proportion to the terminal voltage of the lithium ion secondary batteries 2.

When the total voltage Vb detected by the voltage sensor 12 reaches 14.5 V (at timing T1), the controller 15 switches from constant current charging to constant voltage charging. In response to a control signal from the controller 15, a constant voltage of 14.5 V is applied between the connection terminals 4 and 5 by the charging current supply circuit 14, and constant voltage charging is executed.

As a result, the charging current Ib decreases as the charging depth of the lithium ion secondary batteries 2 is increased by constant voltage charging.

A property of nickel-hydrogen secondary batteries, nickel-cadmium secondary batteries, and other such aqueous secondary batteries is that even if the charging current Ib decreases, the terminal voltage is maintained at a substantially constant voltage value of approximately 1.4 V. Accordingly, the total terminal voltage for the two nickel-hydrogen secondary batteries 3 is 1.4 V x 2 = 2.8 V. As a result, when a voltage of 14.5 V is applied between the connection terminals 4 and 5, the total voltage applied to the three lithium ion secondary batteries 2 is 14.5 V - 2.8 V = 11.7 V.

Therefore, in constant voltage charging of 14.5 V, the charging voltage applied per cell of the lithium ion secondary batteries 2 is 11.7 V /3 = 3.9 V, and as a result, deterioration of the lithium ion secondary batteries 2 can be reduced, as can the risk of safety being compromised.

If the charging current Ib detected by the current sensor 13 is less than the charge cut-off current set ahead of time as the end condition for constant voltage charging, it is determined by the controller 15 that the lithium ion secondary batteries 2 have been charged to a charging depth close to the maximum charging depth possible in constant voltage charging of 14.5 V. In response to a control signal from the controller 15, the output current of the charging current supply circuit 14 is set to zero and charging is ended (at timing T2).

Since the three lithium ion secondary batteries 2 and the two nickel-hydrogen secondary batteries 3 are connected in series, the charging current supplied to each battery is the same. This means that the lithium ion secondary batteries 2, which have a smaller capacity, approach a full charge sooner than the nickel-hydrogen secondary batteries 3, which have a larger capacity, and at the timing T2, the nickel-hydrogen secondary batteries 3 have a shallower charging depth than the lithium ion secondary batteries 2.

For example, if the capacity of the lithium ion secondary batteries 2 is 80% of that of the nickel-hydrogen secondary batteries 3, then when the charging depth of the lithium ion secondary batteries 2 is 100%, for example, the charging depth of the nickel-hydrogen secondary batteries 3 is 80%. This means that if the capacity of the lithium ion secondary batteries 2 is made smaller than the capacity of the nickel-hydrogen secondary batteries, at the timing T2 at which the lithium ion secondary batteries 2 have been charged to closed to a full charge (a charging depth of 100%) and constant voltage charging has ended, the nickel-hydrogen secondary batteries 3 will not exceed full charge (a charging depth of 100%), so there is less risk of the nickel-hydrogen secondary batteries 3 being overcharged, while the charging depth of the lithium ion secondary batteries 2 at the end of charging can be increased.

Also, since charging of the nickel-hydrogen secondary batteries 3 ends before heat is generated near full charge, there is less risk that the lithium ion secondary batteries 2 will be degraded by heat generated near the full charge of the nickel-hydrogen secondary batteries 3.

Also, a characteristic of the nickel-hydrogen secondary batteries is that when they undergo constant voltage charging, there is an increase in charging current near full charge. Accordingly, if the capacity of the nickel-hydrogen secondary batteries 3 should happen to be less than the capacity of the lithium ion secondary batteries 2, the charging circuit will decrease as the lithium ion secondary batteries 2 approach full charge, and before the charging current Ib detected by the current sensor 13 falls below the charging cut-off current, the nickel-hydrogen secondary batteries 3 will approach full charge and the charging circuit will increase, so the charging current Ib will not decrease under the charging cut-off current, which means that charging will continue, without the constant voltage charging ending, so the lithium ion secondary batteries 2 and nickel-hydrogen secondary batteries 3 will be overcharged, and there is the risk that battery performance will suffer or safety will be compromised.

However, the battery pack 1 is such that the lithium ion secondary batteries 2 have a smaller capacity than the nickel-hydrogen secondary batteries 3, so constant voltage charging can be ended before the nickel-hydrogen secondary batteries 3 approach full change and the charging current increases, and as a result there is less risk of battery degradation or of safety being compromised.

It is known that nickel-hydrogen secondary batteries 3 have greater self-discharge current than do lithium ion secondary batteries 2. Accordingly, if the battery pack 1 is left standing after charging, the remaining capacity of the nickel-hydrogen secondary batteries 3 ends up being smaller than the remaining capacity of the lithium ion secondary batteries 2. If the charging of the battery pack 1 is started in a state in which the remaining capacity of the nickel-hydrogen secondary batteries 3 is smaller than the remaining capacity of the lithium ion secondary batteries 2, the charging capacity of the nickel-hydrogen secondary batteries 3 at the end of charging will be reduced by capacity reduced in self-discharge prior to charging, so the charging capacity of the battery pack 1 as a whole ends up being reduced.

The inventors of the present invention discovered by experimentation that if the charging is ended in a state in which the charging depth of the nickel-hydrogen secondary batteries 3 is low, the self-discharge of the nickel-hydrogen secondary batteries 3 is reduced. This means that when the battery pack 1 undergoes constant voltage charging, in a state in which the charging depth of the nickel-hydrogen secondary batteries 3 is low, as the lithium ion secondary batteries 2 approach full charge before the charging current increases, the charging current Ib is reduced below the charging cut-off current, which ends charging, so the charging ends automatically in a state in which the charging depth of the nickel-hydrogen secondary batteries 3 is low, and as a result, self-discharge of the nickel-hydrogen secondary batteries 3 can be reduced. If self-discharge of the nickel-hydrogen secondary batteries 3 is reduced, there is less reduction in the charging capacity of the battery pack 1 overall due to self-discharge of the nickel-hydrogen secondary batteries 3.

The charging circuit 11 is not limited to being a charging circuit intended for a lead storage battery. The numbers of lithium ion secondary batteries 2 and nickel-hydrogen secondary batteries 3 in the battery pack 1 can be suitably set for application to a battery pack 1 that is charged by a charging circuit that performs constant voltage charging at the desired charging voltage.

### Working Examples

The battery packs of the following Working Examples 1 to 3 and Comparative Example 2 were produced using CGR18650DA (capacity of 2.45 Ah) made by Matsushita Battery Industrial as a nonaqueous secondary battery, and using HHR260SCP (capacity of 2.6 Ah) made by Matsushita Battery Industrial, or HHR200SCP (capacity of 2.1 Ah) made by Matsushita Battery Industrial, as an aqueous secondary battery. In Comparative Example 1, LC-P122R2J (capacity of 2.2 Ah) made by Matsushita Battery Industrial was used as a lead storage battery.

### Working Example 1

Three CGR18650DA (capacity of 2.45 Ah) cells and two HHR260SCP (capacity of 2.6 Ah) cells were connected in series (a total of five cells) to obtain the battery pack of Working Example 1.

### Working Example 2

Three CGR18650DA (capacity of 2.45 Ah) cells and three HHR260SCP (capacity of 2.6 Ah) cells were connected in series (a total of six cells) to obtain the battery pack of Working Example 2.

### Working Example 3

Two CGR18650DA (capacity of 2.45 Ah) cells and five HHR260SCP (capacity of 2.6 Ah) cells were connected in series (a total of seven cells) to obtain the battery pack of Working Example 3.

### Comparative Example 1

One LC-P122R2J (capacity of 2.2 Ah) cell was used as the battery pack of Comparative Example 1.

### Comparative Example 2

Three CGR18650DA (capacity of 2.45 Ah) cells and two HHR200SCP (capacity of 2.1 Ah) cells were connected in series (a total of five cells) to obtain the battery pack of Comparative Example 2.

These battery packs of Working Examples 1 to 3 and Comparative Examples 1 and 2 were subjected to constant current, constant voltage charging at a charging current of 1 A in constant current charging, a charging voltage of 14.5 V in constant voltage charging, and a charging cut-off current of 0.1 A, after which they were discharged to 10 V at a constant current of 1 A, and the battery energy density by volume and the battery energy density by weight were measured. The battery energy density by volume and the battery energy density by weight were also measured after the above-mentioned charging and discharging cycle had been repeated 300 times. The measurement results are given in Table 1 below.

**Table 1**

| | Initial | | After 300 cycles | |
|---|---|---|---|---|
| | Volume energy density (Wh/L) | Weight energy density (Wh/kg) | Volume energy density (Wh/L) | Weight energy density (Wh/kg) |
| Working Example 1 | 322 | 112 | 306 | 106 |
| Working Example 2 | 137 | 47 | 130 | 45 |
| Working Example 3 | 211 | 70 | 200 | 67 |
| Comparative Example 1 | 73 | 33 | 51 | 23 |
| Comparative Example 2 | 357 | 127 | 89 | 32 |

As shown in Table 1, with the battery packs of Working Examples 1 to 3 of the present invention, in which aqueous secondary batteries were combined with nonaqueous secondary batteries having a smaller capacity than that of the aqueous secondary batteries, the battery energy density by volume and the battery energy density by weight were sufficiently higher to allow the batteries to be lighter and more compact than the lead storage battery of Comparative Example 1. Also, the battery energy density by volume and the battery energy density by weight after 300 cycles with the battery packs in Working Examples 1 to 3 was sufficiently higher than those of Comparative Examples 1 and 2, and it can be seen that degradation by repeated use can be reduced.

Among Working Examples 1 to 3, it can be seen that the battery pack of Working Example 1, in which three nonaqueous secondary batteries and two aqueous secondary batteries were connected in series, had the highest energy density, and that it was optimal when the numbers of nonaqueous secondary batteries and aqueous secondary batteries had a ratio of 3:2. In Comparative Example 2, in which aqueous secondary batteries were combined with nonaqueous secondary batteries having a larger capacity than that of the aqueous secondary batteries, the initial energy density was higher than that in Working Examples 1 to 3 pertaining to the present invention, but the energy density after 300 cycles decreased greatly, and it can be seen that this battery is not suited to repeated use.

As above, with the battery pack pertaining to the present invention, it is possible to provide a battery pack that is lightweight, compact, and undergoes little deterioration in repeated use, and that can be easily installed in a vehicle as a replacement for a lead storage battery, for example, without modifying the charging circuit.

### Working Example 4

The battery pack 1 shown in FIG. 2 was produced by serially connecting three CGR26650 (capacity of 2.65 Ah) cells made by Matsushita Battery Industrial as the lithium ion secondary batteries 2, and two HHR300SCP (capacity of 3.0 Ah) cells made by Matsushita Battery Industrial as the nickel-hydrogen secondary batteries 3.

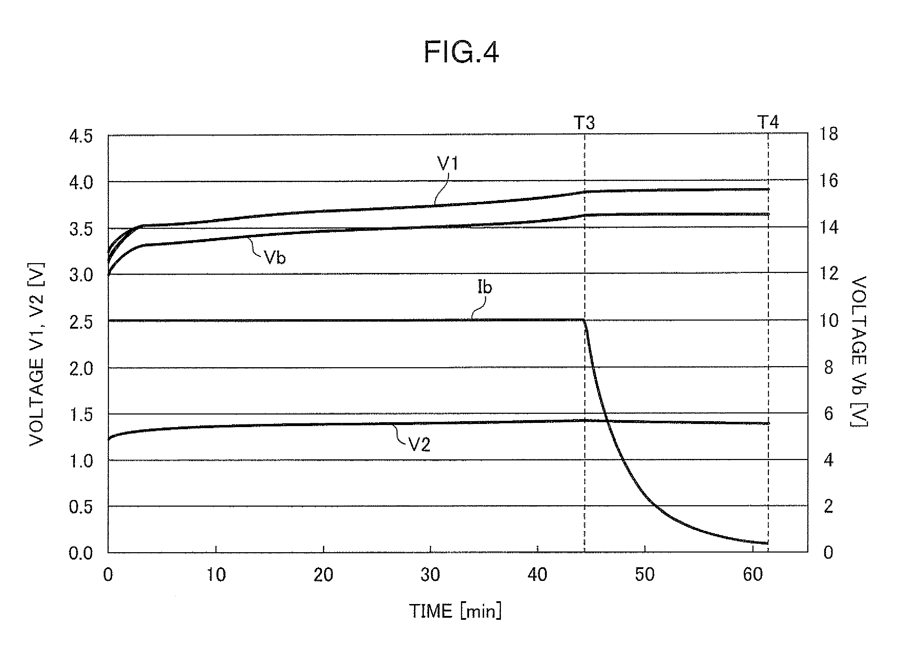

FIG. 4 is a graph of the results of measuring the charging current Ib, the charging voltage Vb (the terminal voltage Vb of the battery pack 1), the terminal voltage V1 of the lithium ion secondary batteries 2, and the terminal voltage V2 of the nickel-hydrogen secondary batteries 3, when the battery pack 1 configured as above was subjected to constant current, constant voltage (CCCV) charging at a temperature of 45°C, with the charging current during constant current charging set to 2.5 A, and the charging voltage during constant voltage charging set to 14.5 V.

In FIG. 4, the horizontal axis is the elapsed time, the left vertical axis is the terminal voltage V1 and V2, and the right vertical axis is the charging voltage Vb. In FIG. 4, the terminal voltage V1 and the terminal voltage V2 are shown as substantially overlapping.

As shown in FIG. 4, when the battery pack 1 constituted as above was subjected to constant current, constant voltage (CCCV) charging with the charging voltage during constant voltage charging set to 14.5 V, from the timing at which there was a switch from constant current charging to constant voltage charging with the charging voltage Vb set at 14.5 (timing T4), even though the charging current Ib decreased as the charging of the lithium ion secondary batteries 2 proceeded, the terminal voltage V2 of the nickel-hydrogen secondary batteries 3 remained almost unchanged, maintained at approximately 1.4 V. Accordingly, the terminal voltage V1 applied to the lithium ion secondary batteries 2 was also substantially constant at 3.9 V.

At the timing T4, at which the charging current Ib had decreased below the charging cut-off current value and constant current, constant voltage (CCCV) charging had ended, the terminal voltage V1 of the lithium ion secondary batteries 2 was maintained at 3.9 V. Consequently, even when constant current, constant voltage (CCCV) charging was performed on the battery pack 1 using 14.5 V as the charging voltage during constant voltage charging, it was confirmed that charging ended without the lithium ion secondary batteries 2 being overcharged.

### Working Example 5

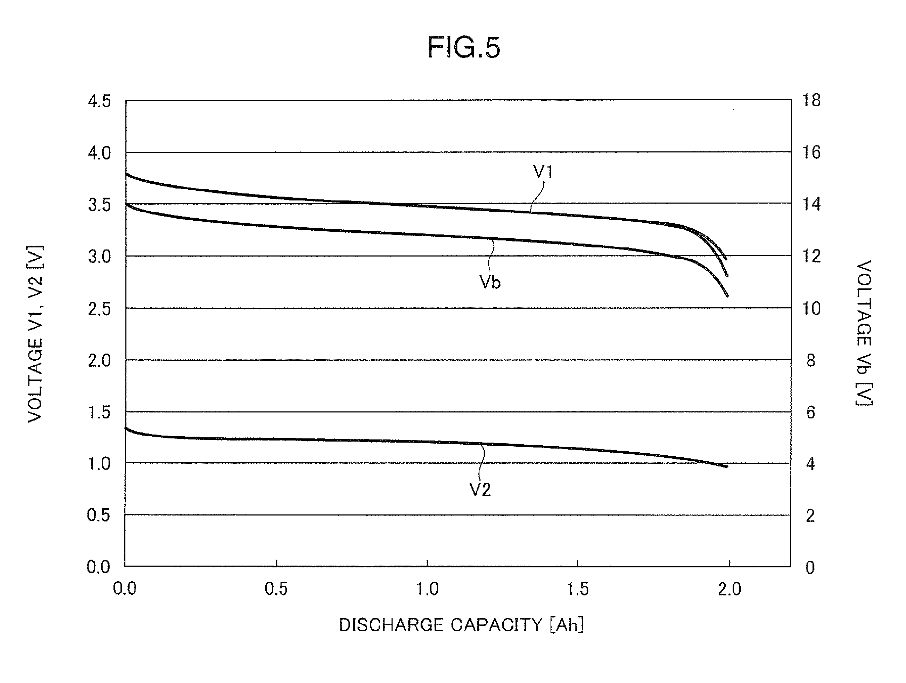

Next, a case in which the battery pack 1 of Working Example 4 is discharged will be described. FIG. 5 is a graph of the results of measuring the terminal voltage Vb of the battery pack 1, the terminal voltage V1 of the lithium ion secondary batteries 2, and the terminal voltage V2 of the nickel-hydrogen secondary batteries 3 when the battery pack 1 of Working Example 4 was discharged at 10 A and at a temperature of 45°C.

In FIG. 5, the horizontal axis is the discharge capacity, the left vertical axis is the terminal voltage V1 and V2, and the right vertical axis is the terminal voltage Vb of the battery pack 1. In FIG. 4, the terminal voltage V1 and the terminal voltage V2 are shown as substantially overlapping.

As shown in FIG. 5, when the battery pack I of Working Example 4 was discharged, the terminal voltage V1 decreased sharply near the point when the discharge capacity reached 2 Ah. At this point the terminal voltage Vb of the battery pack 1 also decreased sharply.

The characteristics of a secondary battery deteriorate when the battery is overcharged. Therefore, during discharge as well, the discharge is preferably controlled so that the terminal voltage of the secondary battery does not drop below a discharge cut-off voltage predetermined so that the secondary battery will not be degraded by overcharging. The discharge cut-off voltage of a lithium ion secondary battery 2 is generally about 2.5 V. The discharge cut-off voltage of a nickel-hydrogen secondary battery 3 is generally about 1.0 V.

With the battery pack 1 shown in FIG. 1, the capacity of the lithium ion secondary batteries 2 is smaller than the capacity of the nickel-hydrogen secondary batteries 3, so when the battery pack 1 is discharged, the lithium ion secondary batteries 2 reach the end of discharge sooner, and as a result, as shown in FIG. 5, the terminal voltage V1 of the lithium ion secondary batteries 2 decreases sharply sooner than does the terminal voltage V2 of the nickel-hydrogen secondary batteries 3. At this point, since the nickel-hydrogen secondary batteries 3 with the larger capacity have not yet reached the end of discharge, the decrease in the terminal voltage V2 is more gentle.

The mid-point discharge voltage of the lithium ion secondary batteries 2 is higher than the mid-point discharge voltage of the nickel-hydrogen secondary batteries 3, so the proportion of the terminal voltage Vb of the battery pack 1 accounted for by the terminal voltage V1 of the lithium ion secondary batteries 2 is greater than the proportion of the terminal voltage Vb of the battery pack 1 accounted for by the terminal voltage V2 of the nickel-hydrogen secondary batteries 3. Accordingly, as is clear from the measurement results shown in FIG. 5, if the terminal voltage V1 decreases sharply, the terminal voltage Vb of the battery pack 1 will also decrease sharply.

Incidentally, if the load that operates upon receipt of power supply from the battery pack 1 is not a simple resistance load, and is instead a load device that does not operate unless a voltage of at least a specific operating power supply voltage Vop required by the device is supplied, such as a personal computer, a communications device, a motor, a pump, a discharge lamp (fluorescent lamp), or another such device, then when the terminal voltage Vb of the battery pack 1 drops below the operating power supply voltage Vop, the operation of the device comes to a stop, and as a result the discharge current of the battery pack 1 is reduced or drops to zero.

For example, when the battery pack 1 is used as an automotive battery, the load that receives the power supply from the battery pack 1 includes load devices such as a fuel pump for supplying fuel from a fuel tank to an engine, a control circuit made up of microprocessors or the like, various sensors, wireless devices, and so on. These load devices have a operating power supply voltage Vop of about 10.0 V to 10.5 V.

Therefore, when the battery pack 1 is used as the above-mentioned automotive battery, when the lithium ion secondary batteries 2 approach the end of discharge, as shown in FIG. 5, the terminal voltage Vb decreases sharply along with the terminal voltage V1. If the terminal voltage Vb drops below 10.5 V, for example, it will drop below the operating power supply voltage Vop of the load device installed in that automobile, and as a result the load device will come to a stop, and the discharge current of the battery pack 1 is reduced or drops to zero.

In this case, since the nickel-hydrogen secondary batteries 3 have not yet reached the end of discharge, there is less risk that the nickel-hydrogen secondary batteries 3 will be overcharged. Also, the terminal voltage V2 here is approximately 1.1 V. This means that the terminal voltage V1 per cell of the lithium ion secondary batteries 2 is {10.5V-(1.1V x 2)}/3 = 2.77 V. Even if the operating power supply voltage Vop is 10.0 V, the terminal voltage V1 when the terminal voltage Vb drops below 10.0 V is {10.0V - (1.1 V x 2)}/3 = 2.6 V.

Specifically, when the battery pack 1 is used to supply power to a load whose operating power supply voltage Vop is 10.0 V to 10.5 V, the discharge of the battery pack 1 can be automatically limited to a voltage that is higher than the 2.5 V that is the discharge cut-off voltage of the lithium ion secondary batteries 2, without providing any separate circuit for preventing overcharging.

The operating power supply voltage Vop is not limited to a range of 10.0 V to 10.5 V. Nor is the number of the nickel-hydrogen secondary batteries 3 limited to two, nor the number of the lithium ion secondary batteries 2 to three. The same effect will be obtained as long as the number of the aqueous secondary batteries and the number of the nonaqueous secondary batteries are set so that the total voltage comprising the sum of the voltage obtained by multiplying the number of the aqueous secondary batteries by the mid-point discharge voltage of the aqueous secondary batteries, and the voltage obtained by multiplying the number of the nonaqueous secondary batteries by the mid-point discharge voltage of the nonaqueous secondary batteries is lower than the operating power supply voltage Vop.

However, if a load device whose operating power supply voltage Vop is between 10.0 V and 10.5 V is connected as the load of the battery pack 1, the battery pack is preferably one in which two nickel-hydrogen secondary batteries 3 and three lithium ion secondary batteries 2 are connected in series. The phrase "a voltage substantially within the range of at least 10.0 V and no more than 10.5 V" means that there is some allowance in the fluctuation for 10.0 V and 10.5 V due to variance in characteristics, output precision error in the charging device, and so forth, and refers to a range of from 10.0 - 0.1 V to 14.5 + 0.1 V, for example.

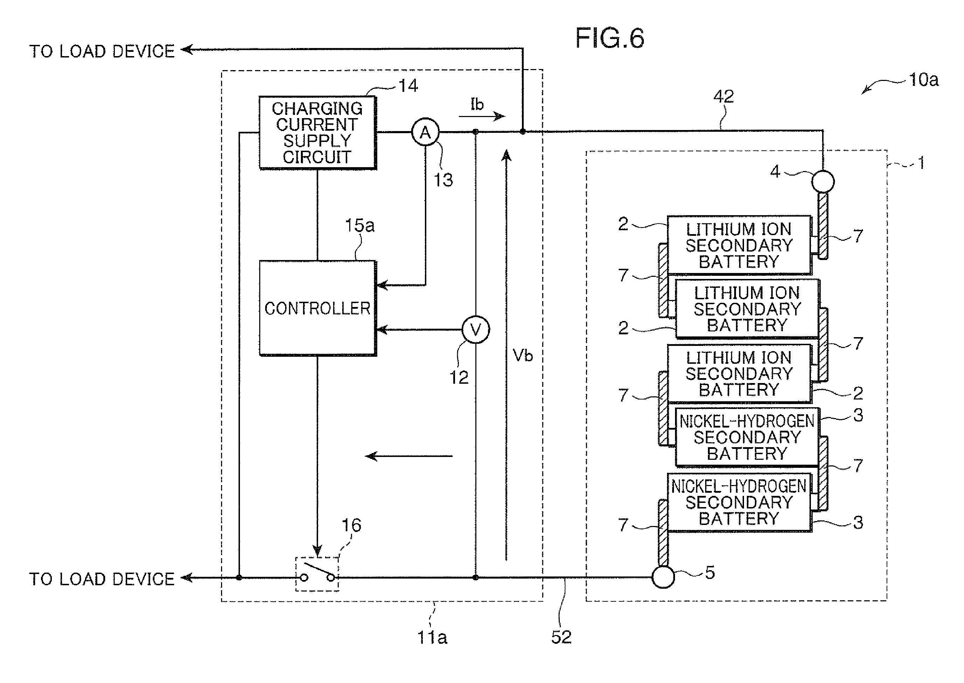

Also, with the battery system 10a shown in FIG. 6, for example, a switching element 16 may be provided that opens and closes a discharge path from the battery pack 1 to the load device, and the opening and closing of the switching element 16 may be controlled by a controller 15a. An FET (field effect transistor) is used, for example, as the switching element 16.

The controller 15a prohibits the discharge of the battery pack 1 by switching off the switching element 16 when the terminal voltage Vb detected by the voltage detector 12 has dropped below a detected discharge cut-off voltage that has been preset to a voltage (such as 10.5 V) that is lower than the total voltage (such as 13V) comprising the sum of the voltage obtained by multiplying the number of the nickel-hydragen secondary batteries 3 (such as two) by the mid-point discharge voltage of the nickel-hydrogen secondary batteries 3 (such as 1.1V), and the voltage obtained by multiplying the number of the lithium ion secondary batteries 2 (such as three) by the mid-point discharge voltage of the lithium ion secondary batteries 2 (such as 3.6 V), and that is higher than the total voltage (such as 9.7 V) comprising the sum of the voltage obtained by multiplying the number of the nickel-hydrogen secondary batteries 3 (such as two) by the mid-point discharge voltage of the nickel-hydrogen secondary batteries 3 (such as 1.1V), and the voltage obtained by multiplying the number of the lithium ion secondary batteries 2 (such as three) by the discharge cut-off voltage of the lithium ion secondary batteries 2 (such as 2.5 V).

Here again, with the battery pack 1 shown in FIG. 1, since the terminal voltage Vb decreases sharply as the lithium ion secondary batteries 2 approach the end of discharge, the voltage sensor 12 and the controller 15a can easily detect that the terminal voltage Vb has dropped below the discharge cut-off voltage and shut off discharge of the battery pack 1.

A battery pack pertaining to one aspect of the present invention comprises at least one aqueous secondary battery and at least one nonaqueous secondary battery having a smaller capacity than that of the aqueous secondary battery, and the aqueous secondary battery and nonaqueous secondary battery are connected in series.

With this constitution, when the battery pack is charged by constant voltage charging, since the charging current flowing through the aqueous secondary battery is equal to the charging current flowing through the nonaqueous secondary battery, the nonaqueous secondary battery, which has a smaller capacity, is reduced in charging current first as full charge is approached, and their constant voltage charging ends first. As a result, when the charging is ended, the aqueous secondary battery, which has a larger capacity than that of the nonaqueous secondary battery, has not yet reached full charge, so there is less risk of overcharging. Furthermore, when the aqueous secondary battery and the nonaqueous secondary battery with different battery characteristics are combined, a wider range of charging characteristics can be obtained by this combination than when the secondary battery of the same type are connected in series, so it is easier to increase the charging depth at the end of charging, with the charging characteristics of the entire battery pack matched to a specific charging voltage.

Also, the aqueous secondary battery and the nonaqueous secondary battery preferably have a different terminal voltage in a fully charged state.

With this constitution, two types of battery with different terminal voltages in a fully charged state are combined into a battery pack. In constant voltage charging, the terminal voltage in a fully charged state is used as the charging voltage per cell, so with a battery pack that combines two types of battery with different terminal voltage in a fully charged state, it is easier to increase the charging depth at the end of charging, with the charging voltage for the battery pack as a whole matched to a specific charging voltage.

Also, it is preferable if connection terminals for receiving charging voltage from a charging circuit that performs constant voltage charging, in which a preset, constant charging voltage is outputted, are provided to both ends of a serial circuit in which the aqueous secondary battery and the nonaqueous secondary battery are connected in series, and if the number of the aqueous secondary battery and the number of the nonaqueous secondary battery are set so that the total voltage comprising the sum of a voltage obtained by multiplying the number of the aqueous secondary battery included in the serial circuit by the terminal voltage in a fully charged state of the aqueous secondary battery, and a voltage obtained by multiplying the number of the nonaqueous secondary battery included in the serial circuit by the terminal voltage in a fully charged state of the nonaqueous secondary battery, is such that the difference between the total voltage and the charging voltage is less than the difference between the charging voltage and a voltage closest to the charging voltage, out of voltages obtained by taking an integer multiple of the terminal voltage in a fully charged state of the nonaqueous secondary battery.

With this constitution, the difference between the total voltage comprising the sum of a voltage obtained by multiplying the number of the aqueous secondary battery included in the serial circuit by the terminal voltage in a fully charged state of the aqueous secondary battery, and a voltage obtained by multiplying the number of the nonaqueous secondary battery included in the serial circuit by the terminal voltage in a fully charged state of the nonaqueous secondary battery, that is, the charging voltage originally required to fully charge this battery pack, and the charging voltage supplied from the charging circuit is less than the voltage closest to the charging voltage supplied from the charging circuit, out of the voltages obtained by taking an integer multiple of the terminal voltage in a fully charged state of the nonaqueous secondary battery. Therefore, when this battery pack is subjected to constant voltage charging by the above-mentioned charging circuit, the battery pack can be charged up to a voltage closer to a full charge than when a battery pack comprising only nonaqueous secondary battery is subjected to constant voltage charging by the above-mentioned charging circuit. In other words, it is possible to increase the charging depth at the end of charging.

Also, it is preferable if the above-mentioned total voltage is at least the above-mentioned charging voltage, and this total voltage is at least the above-mentioned charging voltage and has less of a difference from the charging voltage than a voltage that is greater or equal to the charging voltage and that is closest to the charging voltage, out of the voltages obtained by taking an integer multiple of the terminal voltage in a fully charged state of the nonaqueous secondary battery.

With this constitution, since the total voltage, that is, the charging voltage originally required to fully charge this battery pack, is at least the charging voltage supplied from the charging circuit, there is less risk that over-voltage will be supplied to the battery pack when the battery pack is subjected to constant voltage charging with this charging circuit.

It is preferable if the above-mentioned charging circuit is a charging circuit intended for use with a lead storage battery, and the ratio of the number of the aqueous secondary battery and the number of the nonaqueous secondary battery included in the serial circuit is 2:3.

With this constitution, it is possible to increase the charging depth at the end of charging by reducing the difference between the charging voltage supplied from the charging circuit intended for a lead storage battery and the charging voltage required to fully charge this battery pack.

It is preferable if the above-mentioned charging voltage is substantially 14.5 V, and the serial circuit comprises two aqueous secondary batteries and three nonaqueous secondary batteries that are connected in series.

With this constitution, when 14.5 V is applied to the battery pack to perform constant voltage charging, the charging voltage per nonaqueous secondary battery is lower than the terminal voltage of the nonaqueous secondary battery in a fully charged state, which reduces the risk of overcharging, while the charging depth can be easily increased by raising the charging voltage per nonaqueous secondary battery higher than that with a battery pack in which only nonaqueous secondary battery are connected in series.

Also, the nonaqueous secondary battery preferably has a higher mid-point discharge voltage than the aqueous secondary battery.

With this constitution, since the mid-point discharge voltage of the nonaqueous secondary battery is higher than the mid-point discharge voltage of the aqueous secondary battery, the terminal voltage of the nonaqueous secondary battery accounts for a greater proportion of the terminal voltage of the entire battery pack. This means that if the nonaqueous secondary battery, which has a smaller capacity than that of the aqueous secondary battery, reach the end of discharge sooner than the aqueous secondary battery, and there is a sharp decrease in the terminal voltage of the nonaqueous secondary battery, the decrease in the terminal voltage of the battery pack will also be sharp. Therefore, with a battery pack constituted in this way, it is easy to detect externally that the nonaqueous secondary battery has reached the end of discharge, from the change in terminal voltage. Therefore, it is also easy to detect that the nonaqueous secondary battery has reached the end of discharge, prohibit discharge of the battery pack, and reduce overdischarging. Also, with a battery pack constituted in this way, when the nonaqueous secondary battery reach the end of discharge, the aqueous secondary battery will not yet have reached the end of discharge, so if discharge of the battery pack is prohibited on the basis of the terminal voltage of the battery pack, overdischarging can be easily reduced for both the nonaqueous secondary battery and the aqueous secondary battery.

Also, it is preferable if both ends of a serial circuit, in which the aqueous secondary battery and the nonaqueous secondary battery are connected in series, are provided with connection terminals for supplying a voltage between both ends of a serial circuit, as a power supply voltage to a load device operated by the power supply voltage that is greater than or equal to a preset operating power supply voltage, and if the number of the aqueous secondary battery and the number of the nonaqueous secondary battery are set so that the total voltage comprising the sum of a voltage obtained by multiplying the number of the aqueous secondary battery included in the serial circuit by the mid-point discharge voltage of the aqueous secondary battery, and a voltage obtained by multiplying the number of the nonaqueous secondary battery included in the serial circuit by a discharge cut-off voltage that is preset as a voltage at which discharge is to be halted in order to prevent overdischarging of the nonaqueous secondary battery, is lower than the operating power supply voltage.

With this constitution, the voltage between both ends of a serial circuit of aqueous secondary battery and nonaqueous secondary battery, that is, the terminal voltage of the battery pack, is supplied as the power supply voltage of a load device. Also, the number of the aqueous secondary battery and the number of the nonaqueous secondary battery are set so that the total voltage comprising the sum of a voltage obtained by multiplying the number of the aqueous secondary battery by the mid-point discharge voltage of the aqueous secondary battery, and a voltage obtained by multiplying the number of the nonaqueous secondary battery by the discharge cut-off voltage of the nonaqueous secondary battery, is lower than the operating power supply voltage. As a result, when the battery pack is discharged and the terminal voltage of the nonaqueous secondary battery decreases, the total voltage, that is, the terminal voltage of the battery pack, drops below the operating power supply voltage before the terminal voltage of the nonaqueous secondary battery goes under the discharge cut-off voltage. This means that when the battery pack is connected to a load device that operates when a power supply voltage that is greater than or equal to the operating power supply voltage has been supplied, the load device stops operating and current consumption is reduced before the terminal voltage of the nonaqueous secondary battery goes below the discharge cut-off voltage, and as a result the discharge current of the battery pack is reduced, so there is less risk that the battery pack will be overdischarged.

It is also preferable if the operating power supply voltage is substantially within the voltage range of at least 10.0 V and no more than 10.5 V, and the serial circuit comprises two aqueous secondary batteries and three nonaqueous secondary batteries connected in series.

With this constitution, the total voltage comprising the sum of a voltage obtained by multiplying the number of the aqueous secondary battery by the mid-point discharge voltage of the aqueous secondary battery, and a voltage obtained by multiplying the number of the nonaqueous secondary battery by the discharge cut-off voltage of the nonaqueous secondary battery can be easily set lower than the operating power supply voltage.

It is also preferable if the aqueous secondary battery is a nickel-hydrogen secondary battery. Since the nickel-hydrogen secondary battery has the highest energy density of all aqueous secondary batteries, their use makes it possible for the battery pack to be lighter and more compact.

Also, it is preferable if the nonaqueous secondary battery is a lithium ion secondary battery. Since the lithium ion secondary battery has the highest energy density of all nonaqueous secondary batteries, their use makes it possible for the battery pack to be lighter and more compact.

The battery system pertaining to one aspect of the present invention comprises the above-mentioned battery pack and the above-mentioned charging circuit. With this constitution, the charging circuit subjects the battery pack to constant voltage charging, which reduces the risk of overcharging while increasing the charging depth at the end of charging.

The battery system pertaining to one aspect of the present invention comprises the above-mentioned battery pack, a switching element that opens and closes a discharge path to the load device of the battery pack, a voltage detector that detects a voltage between both ends of the battery pack, and a controller that opens the switching element when a voltage detected by the voltage detector has dropped below a detected discharge cut-off voltage, which is preset to a voltage that is lower than the total voltage comprising the sum of a voltage obtained by multiplying the number of the aqueous secondary battery included in the serial circuit by the mid-point discharge voltage of the aqueous secondary battery, and a voltage obtained by multiplying the number of the nonaqueous secondary battery included in the serial circuit by the mid-point discharge voltage of the nonaqueous secondary battery, and that is higher than the total voltage comprising the sum of a voltage obtained by multiplying the number of the aqueous secondary battery included in the serial circuit by the mid-point discharge voltage of the aqueous secondary battery, and a voltage obtained by multiplying the number of the nonaqueous secondary battery included in the serial circuit by the discharge cut-off voltage of the nonaqueous secondary battery.

With this constitution, if the voltage between both ends of the battery pack as detected by the voltage detector drops below the detected discharge cut-off voltage, the controller opens the switching element and shuts off the discharge current of the battery pack.

The detected discharge cut-off voltage is set lower than the total voltage comprising the sum of a voltage obtained by multiplying the number of the aqueous secondary battery by the mid-point discharge voltage of the aqueous secondary battery, and a voltage obtained by multiplying the number of the nonaqueous secondary battery by the mid-point discharge voltage of the nonaqueous secondary battery. Accordingly, when the aqueous secondary battery and nonaqueous secondary battery each output their mid-point discharge voltage and have yet to reach their end of discharge, the voltage between both ends of the battery pack does not drop below the detected discharge cut-off voltage, and therefore the switching element is not opened by the controller, so discharge is continued.

Furthermore, the detected discharge cut-off voltage is set to a voltage that is higher than the total voltage comprising the sum of a voltage obtained by multiplying the number of the aqueous secondary battery by the mid-point discharge voltage of the aqueous secondary battery, and a voltage obtained by multiplying the number of the nonaqueous secondary battery by the discharge cut-off voltage of the nonaqueous secondary battery. Accordingly, when the nonaqueous secondary battery, which has a smaller capacity than that of the aqueous secondary battery, reach the end of discharge sooner and there is a decrease in the terminal voltage of the nonaqueous secondary battery, the voltage between both ends of the battery pack will drop below the detected discharge cut-off voltage before the terminal voltage of the nonaqueous secondary battery drops below the discharge cut-off voltage. This means that since the controller opens the switching element and the discharge current of the battery pack is shut off, the overdischarging of the nonaqueous secondary battery and aqueous secondary battery is suppressed.

### Industrial Applicability

The battery pack pertaining to the present invention can be utilized favorably as a battery pack used as an automotive battery, such as in a two- or four-wheeled vehicle, a construction vehicle, or the like, or as a battery pack used as a power supply for portable personal computers, digital cameras, portable telephones, and other such electronic devices, or for electric automobiles, hybrid cars, and other such vehicles. A battery system in which this battery pack is used is also favorable.

## Claims

1. A battery pack, comprising:
at least one aqueous secondary battery; and
at least one nonaqueous secondary battery having a smaller capacity than that of the aqueous secondary battery,
wherein the aqueous secondary battery and the nonaqueous secondary battery are connected in series.

2. The battery pack according to Claim 1,
wherein the terminal voltage in a fully charged state is different for the aqueous secondary battery and the nonaqueous secondary battery.

3. The battery pack according to Claim 1 or 2,
wherein connection terminals for receiving charging voltage from a charging circuit that performs constant voltage charging in which a preset, constant charging voltage is outputted are provided to both ends of a serial circuit in which the aqueous secondary battery and the nonaqueous secondary battery are connected in series, and
the number of the aqueous secondary battery and the number of the nonaqueous secondary battery are set so that the total voltage comprising the sum of a voltage obtained by multiplying the number of the aqueous secondary battery included in the serial circuit by the terminal voltage in a fully charged state of the aqueous secondary battery, and a voltage obtained by multiplying the number of the nonaqueous secondary battery included in the serial circuit by the terminal voltage in a fully charged state of the nonaqueous secondary battery, is such that the difference between the total voltage and the charging voltage is less than the difference between the charging voltage and a voltage closest to the charging voltage, out of voltages obtained by taking an integer multiple of the terminal voltage in a fully charged state of the nonaqueous secondary battery.

4. The battery pack according to Claim 3,
wherein the total voltage is set greater than or equal to the charging voltage, and
the difference between the total voltage and the charging voltage is less than the difference between the charging voltage and a voltage that is greater than or equal to the charging voltage and that is closest to the charging voltage, out of the voltages obtained by taking an integer multiple of the terminal voltage in a fully charged state of the nonaqueous secondary battery.

5. The battery pack according to Claim 3 or 4,
wherein the charging circuit is a charging circuit for a lead storage battery, and
the ratio between the number of the aqueous secondary battery and the number of the nonaqueous secondary battery included in the serial circuit is 2:3.

6. The battery pack according to Claim 5,
wherein the charging voltage is substantially 14.5 V, and
the serial circuit comprises two aqueous secondary batteries and three nonaqueous secondary batteries connected in series.

7. The battery pack according to any of Claims 1 to 6,
wherein the nonaqueous secondary battery has a higher mid-point discharge voltage than the aqueous secondary battery.

8. The battery pack according to any of Claims 1 to 7,
wherein both ends of a serial circuit, in which the aqueous secondary battery and the nonaqueous secondary battery are connected in series, are provided with connection terminals for supplying a voltage between both ends of a serial circuit, as a power supply voltage to a load device operated by the power supply voltage that is greater than or equal to a preset operating power supply voltage, and
the number of the aqueous secondary battery and the number of the nonaqueous secondary battery are set so that the total voltage comprising the sum of a voltage obtained by multiplying the number of the aqueous secondary battery included in the serial circuit by the mid-point discharge voltage of the aqueous secondary battery, and a voltage obtained by multiplying the number of the nonaqueous secondary battery included in the serial circuit by a discharge cut-off voltage that is preset as a voltage at which discharge is to be halted in order to prevent overdischarging of the nonaqueous secondary battery, is lower than the operating power supply voltage.

9. The battery pack according to Claim 8,
wherein the operating power supply voltage is substantially within the voltage range of at least 10.0 V and no more than 10.5 V, and
the serial circuit comprises two aqueous secondary batteries and three nonaqueous secondary batteries connected in series.

10. The battery pack according to any of Claims 1 to 9,
wherein the aqueous secondary battery is a nickel-hydrogen secondary battery.

11. The battery pack according to any of Claims 1 to 10,
wherein the nonaqueous secondary battery is a lithium ion secondary battery.

12. A battery system, comprising:
the battery pack according to any of Claims 3 to 6; and
the charging circuit.

13. A battery system, comprising:
the battery pack according to Claim 8 or 9;
a switching element that opens and closes a discharge path to the load device of the battery pack;
a voltage detector that detects a voltage between both ends of the battery pack; and
a controller that opens the switching element when a voltage detected by the voltage detector has dropped below a detected discharge cut-off voltage, which is preset to a voltage that is lower than the total voltage comprising the sum of a voltage obtained by multiplying the number of the aqueous secondary battery included in the serial circuit by the mid-point discharge voltage of the aqueous secondary battery, and a voltage obtained by multiplying the number of the nonaqueous secondary battery included in the serial circuit by the mid-point discharge voltage of the nonaqueous secondary battery, and that is higher than the total voltage comprising the sum of a voltage obtained by multiplying the number of the aqueous secondary battery included in the serial circuit by the mid-point discharge voltage of the aqueous secondary battery, and a voltage obtained by multiplying the number of the nonaqueous secondary battery included in the serial circuit by the discharge cut-off voltage of the nonaqueous secondary battery.
